# EUROPÄISCHE PATENTSCHRIFT

(11) **EP 1 995 600 B1**
(45) Veröffentlichungstag und Bekanntmachung des Hinweises auf die Patenterteilung: **07.02.2018**
(21) Anmeldenummer: 08008651.5
(22) Anmeldetag: 08.05.2008
(51) Int. Cl.: G01R 31/02

(54) **Tisch für die Montage und/oder Prüfung eines Prüflings**
Table for mounting and/or testing test pieces
Table de montage et/ou de vérification d'un échantillon

(30) Priorität: 25.05.2007 DE 102007024601
(43) Veröffentlichungstag der Anmeldung: 26.11.2008
(73) Patentinhaber: Engberts GmbH, 26188 Edewecht (DE)
(72) Erfinder: Decker, Rainer, 26349 Jade (DE); Xanke, Marco, 26129 Oldenburg (DE)
(74) Vertreter: Diehl & Partner GbR

(56) Entgegenhaltungen:
- EP-A- 1 262 783
- WO-A1-01/79871
- DE-A1- 10 218 411
- DE-A1- 19 500 113
- DE-U1- 29 920 214
- JP-A- 6 258 371
- JP-A- 2006 292 405
- US-A1- 2003 144 817

## Beschreibung

### Stand der Technik

Aus der DE 195 00 113 A1 ist ein Adapter bekannt, der komplementär zu einem Steckverbinder eines Kabels ausgebildet ist und der zum Anschluss an eine elektronische Datenverarbeitungsanlage vorgesehen ist, wobei der Adapter einen Speicher aufweist, in welchem Daten über den Adapter gespeichert sind.

Aus JP 06258371 A ist eine Prüfvorrichtung zur Kontrolle eines Kabelstrangs bekannt, bei der verschiedene Eigenschaften der Leiter und Verbindungen des Kabelstrangs in separaten Modulen bestimmt und die Ergebnisse an eine Mastereinheit übertragen werden.

### Darstellung der Erfindung

Der Erfindung liegt die Aufgabe zu Grunde, einen Tisch für die Montage und Prüfung eines Prüflings derart weiter zu entwickeln, dass sich eine deutliche Verbesserung hinsichtlich der qualitativen Auswertungsmöglichkeiten der jeweils angeschlossenen Prüflinge ergibt. Diese können durch Kabel und/oder ein Gerät und/oder einen sonstigen Gegenstand gebildet sein.

Diese Aufgabe wird erfindungsgemäß mit einer Vorrichtung nach Anspruch 1 gelöst. Auf vorteilhafte Weiterbildungen nehmen die jeweiligen Unteransprüche Bezug.

Demgemäss ist zumindest eine Steckplatte mit einer Vielzahl von elektrisch gegeneinander isolierten Kontaktelementen und mindestens einem modulartigen Adapter vorgesehen, der in zumindest einer Ausrichtung an einer beliebigen Stelle der Steckplatte zugleich mit wenigstens zwei Kontaktelementen verbindbar ist, dass die Kontaktelemente in einem Kontaktelementmuster verteilt sind, das in horizontaler und vertikaler Richtung regelmäßig wiederkehrend aufeinander folgt, dass die Kontaktelemente durch wenigstens zwei elektrisch gegeneinander isolierte Signalleiter mit verschiedenen elektrischen Potentialen belegt sind, dass sich mindestens zwei Signalleiter mit verschiedenen elektrischen Potentialen kreuzen, dass der Adapter mit allen Potenzialen zumindest einmal verbindbar ist, einen Identifizierungscode und eine interne Steuerung besitzt, die eine Entnahme von Versorgungsstroms aus den Signalleitern und deren Identifizierung bewirkt und die geeignet ist, mit einem Rechner und/oder einem anderen Adapter zu kommunizieren, dass die Steckplatte und/oder der Adapter und/oder ein externer Rechner, jeder für sich und/oder im Zusammenspiel miteinander, erste Mittel umfassen, die eine Erkennung der jeweiligen Position des Adapters auf der Steckplatte bewirken, das die elektrischen Potentiale an den Kontaktelementen in wenigstens einem Potentialmuster verteilt sind, das in horizontaler und vertikaler Richtung regelmäßig wiederkehrend folgt und dass jeder Adapter mit dem Prüfling in Eingriff bringbar ist und zweite Mittel umfasst, die die Montage und die Prüfung des Prüflings unterstützen und/oder bewirken. Der Tisch kann durch diese Ausbildung zur Montage und Prüfung von ganz unterschiedlichen Prüflingen verwendet werden.

Nach einer vorteilhaften Ausgestaltung ist es im einfachsten Falle vorgesehen, dass die Kontaktelemente mit einem rechteckigen Potenzialmuster belegt sind und dass in der ersten Zeile wenigstens zwei voneinander verschiedene, regelmäßig wiederkehrend aufeinanderfolgende, erste Potenziale vorgesehen sind und in der zweiten Zeile nur ein zweites, regelmäßig wiederkehrendes Potenzial.

Die Kontaktelemente können auch mit einem rechteckigen Potenzialmuster belegt sein, wobei in der ersten und zweiten Zeile wenigstens zwei voneinander verschiedene, regelmäßig wiederkehrend aufeinanderfolgende, erste Potenziale vorhanden sind mit der Maßgabe, dass die Potenziale in der ersten und zweiten Zeile in umgekehrter Richtung aufeinanderfolgen.

Die Kontaktelemente können mit wenigstens zwei von einander verschiedenen, quadratischen Potenzialmustern belegt sein, die Potenzialmuster sich horizontal und vertikal regelmäßig abwechselnd wiederholen, wobei die Potenzialmuster jeweils vier Potenziale umfassen, die einander diagonal gegenüberliegend mit identischen und, bezogen auf einander, mit verschiedenen Potenzialen belegt sind.

Falls es dabei vorgesehen ist, dass die Kontaktelemente mit zwei von einander verschiedenen, quadratischen Potenzialmustern belegt sind, besteht die Möglichkeit, dass die Potenzialmuster sich horizontal und vertikal regelmäßig abwechselnd wiederholen, wobei die in dem ersten Potenzialmuster enthaltenen, horizontal nebeneinander liegenden Kontaktelemente mit identischen und die vertikal übereinanderliegenden Kontaktelemente mit verschiedenen Potenzialen belegt sind, dass die in dem zweiten Potenzialmuster enthaltenen, vertikal übereinander liegenden Kontaktelemente mit identischen und die horizontal nebeneinander liegenden Kontaktelemente mit verschiedenen Potenzialen belegt sind, wobei die Potenziale der beiden Potenzialmuster voneinander verschieden sind.

Nach einer anderen Ausgestaltung ist es vorgesehen, dass jeweils sechs Kontaktelemente in einem Kontaktelementmuster zusammengefasst sind, das die Gestalt eines gleichseitigen Sechsecks hat und sich horizontal und vertikal nach Art einer Bienenwabe wiederholt.

Ferner können jeweils mindestens vier Kontaktelemente in dem Potenzialmuster zusammengefasst sein, die auf der Steckplatte in einem sich horizontal und vertikal regelmäßig wiederholenden, rautenförmigen Potentialmuster verteilt sind.

Bei einem Tisch, bei dem mehr als zwei Signalleiter mit verschiedenen elektrischen Potenzialen vorhanden sind, ist es nach einer weiteren Ausgestaltung vorgesehen, dass wenigstens zwei erste Signalleiter parallel zueinander verlaufend als Signalleitergruppe ausgebildet sind und gemeinsam wenigstens einen zweiten Signalleiter überkreuzen.

Falls dabei wenigstens zwei zweite Signalleiter parallel zueinander verlaufend angeordnet sind, können diese als zweite Signalleitergruppe ausgebildet sein.

Es können auch alle Signalleiter jeweils zu Signaleitergruppen zusammengefasst sein, in denen die Signalleiter regelmäßig wiederkehrend aufeinander folgen, wobei die Signalleitergruppen in ersten und sich damit überkreuzenden zweiten Signalleiterscharen regelmäßig widerkehrend aufeianderfolgen, die über die Steckplatte in ihrer Gesamtheit verteilt sind.

Dabei hat es sich als zweckmäßig erwiesen, wenn die Signalleitergruppen der beiden Signalleiterscharen eine jeweils übereinstimmende Anzahl von Signalleitern enthalten.

Die ersten und die zweiten Signalleiter können dabei einander unter einem Winkel C von 90° zugeordnet sein.

Die Kontaktelemente können auf der Seite der Steckplatte durch Buchsen gebildet sein. Der ortsfeste Anschluss von mit entsprechend positionierten und gestalteten Steckern versehenen Adaptern ist dann ganz besonders einfach.

Als vorteilhaft hat es sich bewährt, wenn die verfügbaren Signalleiter zwei Signalleiter umfassen, die die Funktion eines Kommunikations - Busses haben. Dies ermöglicht eine einfache und gezielte Ansteuerung des jeweiligen Adapters sowie eine gegenseitige Kommunikation der Adapter miteinander. Diese kann sinnvoll sein, um komplexe Prüfaufgaben zu erledigen.

Ferner können die Signalleiter zwei Signalleiter umfassen, die die Funktion einer Mess - Leitung haben, um mit Hilfe des jeweiligen Adapters die jeweils erforderliche Qualitätsmessung des angeschlossenen Kabels und/oder Gerätes vornehmen zu können.

Ferner können die Signalleiter zwei Signalleiter umfassen, die die Funktion der Stromversorgung des jeweiligen Adapters haben. Dadurch ist es möglich, die unterschiedlichsten Auswertungen an den jeweils angeschlossenen Prüflingen vorzunehmen.

Als vorteilhaft hat es sich bewährt, wenn mindestens ein Adapter mit einer Messeinrichtung zur Bestimmung der Induktivität, der Spannung, des Widerstandes und/oder der Kapazität eines daran angeschlossenen elektrischen Leiters z.B. eines Kabelbaums verbunden oder versehen ist. Der Adapter kann somit von einer Zentraleinheit unterstützt werden, die weitere und /oder spezielle Messeinrichtungen enthält. Die Widerstandsbestimmung ist z.B. nach wie vor eine der wichtigsten Auswertungen elektrisch leitfähiger Kabel, die es zugleich ermöglicht, eine Aussage darüber zu treffen, ob ein Kabel tatsächlich angeschlossen ist oder nicht und/oder ob Kurzschlüsse vorhanden sind.

Ferner kann mindestens ein Adapter zur Bestimmung der Signaldämpfung eines Lichtwellenleiters vorhanden sein. Lichtwellenleiter erlangen auch in Kraftfahrzeugen eine zunehmende Bedeutung und können von daher neben elektrischen Leitern ebenfalls in einem Kabelbaum enthalten sein. Derart gemischt aufgebaute Kabelbäume sind somit ebenfalls prüfbar, ohne dass es dazu gesonderter Prüfeinrichtungen bedarf.

Als vorteilhaft hat es sich bewährt, wenn die Steckplatte aus mehreren Steckmodulen zusammengesetzt ist und durch Anfügen und/oder Entnehmen weiterer Steckmodule nach Bedarf in Längs- und/oder Querrichtung vergrößerbar und/oder verkleinerbar ist. Dadurch ist es möglich, den Tisch kostengünstig z.B. in Abhängigkeit von der Größe und Gestalt eines jeweils herzustellenden Kabelbaums auszubilden und eine einmal vorhandene Grundausstattung von Steckmodulen und Adaptern für die Herstellung und/oder Prüfung der verschiedensten Kabelbäume und/oder Gegenstände zu verwenden. Kabelbäume gelangen nicht nur in Kraftfahrzeugen zur Anwendung, sondern auch in Elektrogeräten des täglichen Bedarfs, wie z. B. in Küchengeräten und in Geräten der Unterhaltungselektronik. Ferner ist es nicht mehr nötig, starr gebaute Tische 10 Jahre lang über die Produktionszeit eines Gerätes oder Produktes hinaus zu bevorraten, sondern möglich, den Tisch im Falle eines solchen Bedarfs aus Steckmodulen zusammenzusetzen und dann zu verwenden. Unter wirtschaftlichen Gesichtspunkten ist das von großem Vorteil.

Um die Steckmodule so zusammenzufügen, dass sie vom Computer hinsichtlich ihrer jeweiligen Positionierung richtig erkannt werden können, ist es erforderlich, eine Grundplatte zu verwenden, die entweder analog zu der Steckplatte zwei einander überkreuzende Gruppen von Signalleitern mit Kontaktelementen hat, auf die die Steckmodule aufsteckbar sind, wobei eine in einem jeden Steckmodul enthaltene Steuerung mit einer eindeutigen Adresse versehen ist, die es erlaubt, die jeweilige Position über zwei Signalleiter im Zusammenspiel mit der Grundplatte zu erfassen und korrekt an einen daran angeschlossenen Computer zu übermitteln. In der Grundplatte sind dabei elektronische oder elektromechanische Schalter integriert, die im Sinne der obigen Ausführung geschaltet werden und so eine Serienabfrage zur Identifizierung der jeweiligen Position des Steckmoduls gestatten. Die betreffenden beiden Signalleiter müssen dabei einander überkreuzend in der Grundplatte verlegt sein um sowohl in der horizontalen als auch in der vertikalen Richtung die genaue Position erfassen zu können. Die Grundplatte kann bedarfsweise auch als Gerüst gestaltet sein, wenn die Möglichkeit besteht, die einzelnen Steckmodule sinngemäß daran zu befestigen und sie sinngemäß zu versorgen.

Die Anzahl der in der Grundplatte verwendeten Signalleiter darf dabei nicht kleiner sein, als zum Betrieb der Adapter benötigt.

Der Tisch kann demgemäss vorteilhaft einen modulartig aufgebauten Bausatz aus zumindest einer Grundplatte, einem Adapter und einem Steckmodul umfassen, die zur geometrisch korrekten Verlegung und/oder Prüfung eines Prüflings nach Bedarf computergesteuert zusammensteckbar und voneinander lösbar sind.

Der Tisch lässt sich besonders gut für die Verlegung und/oder Prüfung von Kabelbäumen verwenden. Die geometrisch korrekte Belegung mit den in dem Kabelbaum enthaltenen Kabeln kann dabei von einem Rechner gesteuert erfolgen, indem die durch die jeweiligen Kabel zu verbindenden Adapter paarweise aufeinanderfolgend durch Anzeigen markiert werden, beispielsweise durch eine Leuchtdiodenanzeige oder den Bildschirm des Rechners, wobei eine Messeinrichtung vorgesehen ist, die bei korrekter Belegung eines jeden Paares von durch ein Kabel verbundenen Adaptern eine Umschaltung der Anzeige zu dem nächstfolgenden Paar zu belegender Adapter bewirkt.

Ferner lässt sich der Tisch auch bei der Prüfung von Prüflingen verwenden, die von Kabelbäumen abweichen, beispielsweise zur Prüfung von Schuhen, Toastern und/oder Waschmaschinen. Dazu werden die Adapter so ausgewählt und auf der Steckplatte computergesteuert so platziert, dass die zu prüfende Eigenschaft unmittelbar von den Adaptern erkannt und bei Bedarf protokolliert wird, beispielsweise die Farbe oder das Vorhandensein bestimmter Accessoires. Damit stellt die Erfindung ein frei gestaltbares Testsystem bereit, das auf der Grundlage eines in einem Rechner abgespeicherten Datensatzes jederzeit reproduziert und in Benutzung genommen werden kann.

Die dabei zur Anwendung gelangenden Steckmodule können jedes beliebige Grundraster haben, beispielsweise ein rechteckiges oder ein dreieckiges Grundraster. Bevorzugt gelangen jedoch im Rahmen der Erfindung Steckmodule zur Anwendung, die quadratisch begrenzt sind. Sie können auch rautenförmig oder sechseckig begrenzt ausgebildet sein.

Die Erfindung lässt sich auch in Gestalt eines modulartig aufgegebauten Bausatzes aus zumindest einer Grundplatte, einem Adapter und einem Steckmodul verwenden, die zur geometrisch korrekten Verlegung, Montage und/oder Prüfung eines Kabelbaums nach Bedarf computergesteuert zusammensteckbar und voneinander lösbar sind, insbesondere bei der Montage und Prüfung von von Kabelbäumen abweichenden Prüflingen.

Ferner müssen die Kontaktelemente für den Anschluss des Adapters so ausgewählt werden, dass alle verfügbaren Potenziale wenigstens einmal an den Adapter angeschlossen werden können und für die darin enthaltene Steuerung verfügbar sind.

Die Positionierung der Adapter auf der Steckplatte kann computergesteuert erfolgen, wobei jeder Adapter zunächst nur den Versorgungsstrom aus dem betreffenden Signalleiter entnimmt und der enthaltenen Steuerung zuführt. Dieser enthält eine Schaltung, die geeignet ist, die Signalleiter sämtlich richtig zu erkennen und richtig zu verbinden. Jeder Adapter ist anschließend mit den in der Steckplatte benötigten Potenzialen korrekt verbunden.

Jeder Adapter enthält ferner einen Identifizierungscode, der es einem mit den Signalleitern verbundenen Rechner ermöglicht, mit jedem anderen Adapter gezielt zu kommunizieren. Der Identifizierungscode kann in einem Mikroprozessor abgespeichert sein. Der Adapter kann damit breit gefächert verwendet werden mit erheblichen Möglichkeiten, darauf Bus - gesteuert zuzugreifen und ihn für vielfältige Aufgaben bei der Kontrolle der jeweils angeschlossenen Prüflinge nutzbar zu machen. Die Prüflinge können durch Kabel oder beliebige Geräte gebildet sein oder zumindest ein solches enthalten.

Es besteht auch die Möglichkeit, den Adapter nach freier Wahl auf der Steckplatte zu platzieren, wobei er ebenfalls zunächst nur den Versorgungsstrom aus dem bereffenden Signalleiter entnimmt und den Signalleiter mit der enthaltenen Steuerung verbindet. Durch die darin enthaltene Schaltung wird wiederum die richtige Verbindung mit sämtlichen Signalleitern der einander überkreuzenden Scharen von regelmäßig wiederkehrenden Gruppen aus parallel verlaufenden Signalleitern hergestellt. In den Gruppen aus parallel zueinander verlaufenden Signalleitern der Scharen ist regelmäßig wiederkehrend ein Leiter vorhanden, der sich mit einem anderen Leiter überkreuzt, wobei die Steckplatte mit elektronischen oder elektromechanischen Schaltern versehen ist, die es erlauben, die jeweiligen Leiter der beiden Scharen programmgesteuert zu schalten. Die Steuerung des Adapters kann diesen Signalwechsel erkennen, wenn die Zentraleinheit einen Signalzustand durch einfaches elektrisches Überbrücken herstellt.

Als Alternative dazu kann die Zentraleinheit den Signalwechsel erkennen, wenn die Steuerung des Adapters einen Signalzustand herstellt, z.B. durch einfaches elektrisches Überbrücken.

Die vom Adapter oder der Zentraleinheit ermittelten, signalwechselauslösenden, elektronischen oder elektromechanischen Schalter der Steckplatte des Tisches in logischer Verknüpfung mit der vom Adapter ermittelten Signalleiteranordnung liefern dann die exakte Position und Ausrichtung des jeweiligen Adapters.

Die Steuerung des Adapters kann somit seinen Identifizierungscode und im Zusammenspiel mit der Zentraleinheit und Steckplatte seine Position und Ausrichtung auf der Steckplatte erkennen und einem zentralen Rechner übermitteln. Dadurch besteht die Möglichkeit, auch auf der Grundlage von Versuchen eine optimierte Positionierung und Ausrichtung der Adapter zu erzielen, diese in dem Rechner abzuspeichern und bei späterem Bedarf gezielt aufs neue herzustellen.

Falls die Signalleiter geneigt verlaufend angeordnet sind, ist es erforderlich, den Winkel in Abhängigkeit von der Gestaltung der Adapter und des Grundrasters der Kontaktelemente zu wählen.

Wenn die Signalleiter einander überkreuzen, ist eine symmetrische Zuordnung der Neigung zu dem Grundraster bzw. zur horizontalen und vertikalen Richtung sinnvoll. Als vorteilhaft hat es sich bewährt, wenn der Winkel B 45° und der Winkel C 90° beträgt. Die Adapter können dadurch nach jeweiligem Erfordernis wahlweise mit einer Ausrichtung nach links oder rechts, nach oben oder unten auf die Steckplatte aufgesetzt werden, was die Verwendung dann vereinfacht, wenn beide Gruppen von parallel verlaufenden Signalleitern eine übereinstimmende Anzahl von Signalleitern enthalten.

Die Anzeige kann dabei unmittelbar den Adaptern zugeordnet und beispielsweise durch mindestens eine Leuchtdiode gebildet sein. Es ist aber auch möglich, eine Anzeige eines Computers zu verwenden, beispielsweise einen Bildschirm. Ein Computer bietet dabei die Möglichkeit, sowohl den Ort der Platzierung automatisch zu erkennen und diesbezügliche Fehler und Korrekturhilfen anzuzeigen, als auch die Möglichkeit, Messwerte zu erfassen, zur Anzeige zu bringen und gegebenenfalls zu protokollieren.

Die Kontaktelemente können auf der Seite der Steckplatte durch Buchsen gebildet sein. Ihre praktische Verwendung ist dadurch stark vereinfacht.

Als vorteilhaft hat es sich bewährt, wenn die Anzahl der in den einander überkreuzenden Gruppen enthaltenen Signalleiter mindestens sechs beträgt. Unter Ausnutzung der von Mikroprozessoren gebotenen Möglichkeiten lassen sich bereits damit vielfältige Aufgaben lösen.

Die Gruppen können eine unterschiedliche oder eine identische Anzahl von Signalleitern enthalten. Nach oben sind den Bereichen keine Grenzen gesetzt.

Die vorliegende Offenbarung bezieht sich auf
Punkt 1: einen Tisch für die Montage und Prüfung eines Prüflings, wobei zumindest eine Steckplatte mit einer Vielzahl von elektrisch gegeneinander isolierten Kontaktelementen und mindestens einem modulartigen Adapter vorgesehen ist, der in zumindest einer Ausrichtung an einer beliebigen Stelle der Steckplatte zugleich mit wenigstens zwei Kontaktelementen verbindbar ist, dass die Kontaktelemente in einem Kontaktelementmuster verteilt sind, das in horizontaler und vertikaler Richtung regelmässig wiederkehrend aufeinander folgt, dass die Kontaktelemente durch wenigstens zwei elektrisch gegeneinander isolierte Signalleiter (N, O, P, Q, R, S) mit verschiedenen elektrischen Potentialen belegt sind, dass der Adapter mit allen Potenzialen zumindest einmal verbindbar ist, einen Identifizierungscode und eine interne Steuerung besitzt, die eine Entnahme von Versorgungsstroms aus den Signalleitern (N, O, P, Q, R, S) und deren Identifizierung bewirkt und die geeignet ist, mit einem Rechner und/oder einem anderen Adapter zu kommunizieren, dass die Steckplatte und/oder der Adapter und/oder ein externer Rechner, jeder für sich und/oder im Zusammenspiel miteinander, erste Mittel umfassen, die eine Erkennung der jeweiligen Position des Adapters auf der Steckplatte bewirken, das die elektrischen Potentiale an den Kontaktelementen in wenigstens einem Potentialmuster (X1, X2, X3, X4, X5, X6, X7) verteilt sind, das in horizontaler und vertikaler Richtung regelmässig wiederkehrend folgt und dass jeder Adapter mit dem Prüfling in Eingriff bringbar ist und zweite Mittel umfasst, die die Montage und die Prüfung des Prüflings unterstützen und/oder bewirken.
Punkt 2: einen Tisch nach Punkt 1, wobei die Kontaktelemente mit einem rechteckigen Potenzialmuster X1 belegt sind und dass in der ersten Zeile wenigstens zwei voneinander verschiedene, regelmässig wiederkehrend aufeinanderfolgende erste Potenziale vorgesehen sind und in der zweiten Zeile nur ein zweites, regelmässig wiederkehrendes Potenzial.
Punkt 3: einen Tisch nach Punkt 1, wobei die Kontaktelemente mit einem rechteckigen Potenzialmuster X2 belegt sind, dass in der ersten und zweiten Zeile wenigstens zwei voneinander verschiedene, regelmässig wiederkehrend aufeinanderfolgende, erste Potenziale umfasst mit der Massgabe, dass die Potenziale in der ersten und zweiten Zeile in umgekehrter Richtung aufeinanderfolgen.
Punkt 4: einen Tisch nach Punkt 1, bei dem die Kontaktelemente mit wenigstens zwei von einander verschiedenen, quadratischen Potenzialmustern X2, X3 belegt wobei die Potenzialmuster X2, X3 sich horizontal und vertikal regelmässig abwechselnd wiederholen, dass das Potenzialmuster X2, X3 jeweils vier Potenziale umfasst, die einander diagonal gegenüberliegend mit identischen und, bezogen auf einander, mit verschiedenen Potenzialen belegt sind.
Punkt 5: einen Tisch nach Punkt 1, bei dem die Kontaktelemente in zwei von einander verschiedenen, quadratischen Potenzialmustern X4, X5 belegt wobei die Potenzialmuster X4, X5 sich horizontal und vertikal regelmässig abwechselnd wiederholen, dass die in dem Potenzialmuster X4 enthaltenen, horizontal nebeneinander liegenden Kontaktelemente mit identischen und die vertikal übereinanderliegenden Kontaktelemente mit verschiedenen Potenzialen belegt sind, dass die in dem Potenzialmuster X5 enthaltenen, vertikal übereinander liegenden Kontaktelemente mit identischen und die horizontal nebeneinander liegenden Kontaktelemente mit verschiedenen Potenzialen belegt sind, und dass die Potenziale der Potenzialmuster X4 und X5 voneinander verschieden sind.
Punkt 6: einen Tisch nach Punkt 1, wobei jeweils sechs Kontaktelemente in einem Kontaktelementmuster zusammengefasst sind, das die Gestalt eines gleichseitigen Sechsecks hat und sich horizontal und vertikal nach Art einer Bienenwabe wiederholt.
Punkt 7: einen Tisch nach Punkt 1, wobei jeweils mindestens vier Kontaktelemente in dem Potenzialmuster zusammengefasst sind, die auf der Steckplatte in einem sich horizontal und vertikal regelmässig wiederholenden, rautenförmigen Potentialmuster X7 verteilt sind.
Punkt 8: einen Tisch nach einem der Punkte 1 bis 7, bei dem mehr als zwei Signalleiter (N, O, P, Q, R, S) mit verschiedenen elektrischen Potenzialen vorhanden sind, wobei wenigstens zwei erste Signalleiter (N, O, P, Q, R, S) parallel zueinander verlaufend als Signalleitergruppe ausgebildet sind und gemeinsam wenigstens einen zweiten Signalleiter (N, O, P, Q, R, S) überkreuzen.
Punkt 9: einen Tisch nach Punkt 8, wobei wenigstens zwei zweite Signalleiter (N, O, P, Q, R, S) parallel zueinander verlaufend angeordnet und als zweite Signalleitergruppen ausgebildet sind.
Punkt 10: einen Tisch nach einem der Punkte 1 bis 9, bei dem die Signalleiter (N, O, P, Q, R, S) zu Signaleitergruppen zusammengefasst sind, wobei die Signalleiter (N, 0, P, Q, R, S) in den Signaleitergruppen regelmässig wiederkehrend aufeinander folgen und dass die Signalleitergruppen in ersten und sich damit überkreuzenden zweiten Signalleiterscharen regelmässig wiederkehrend aufeinander folgen, die über die Steckplatte in ihrer Gesamtheit verteilt sind.
Punkt 11: einen Tisch nach Punkt 10, wobei die Signalleitergruppen der beiden Signalleiterscharen eine übereinstimmende Anzahl von Signalleitern (N, 0, P, Q, R, S) enthalten.
Punkt 12: einen Tisch nach einem der Punkte 1 bis 11, wobei die Signalleiter ersten und die zweiten Signalleiter (N, O, P, Q, R, S) umfassen, die einander unter einem Winkel C von 90 ° zugeordnet sind.
Punkt 13: einen Tisch nach einem der Punkte 1 bis 12, wobei die Kontaktelemente auf der Seite der Steckplatte durch Buchsen gebildet sind.
Punkt 14: einen Tisch nach einem der Punkte 1 bis 13, wobei die Signalleiter (N, O, P, Q, R, S) zwei Signalleiter (N, O, P, Q, R, S) umfassen, die die Funktion eines Kommunikations - Busses haben.
Punkt 15: einen Tisch nach einem der Punkte 1 bis 14, wobei die Signalleiter (N, 0, P, Q, R, S) zwei Signalleiter (N, 0, P, Q, R, S) umfassen, die die Funktion einer Mess - Leitung haben.
Punkt 16: einen Tisch nach einem der Punkte 1 bis 15, wobei die Signalleiter (N, O, P, Q, R, S) zwei Signalleiter (N, O, P, Q, R, S) umfassen, die die Funktion der Stromversorgung des jeweiligen Adapters haben.
Punkte 17: einen Tisch nach einem der Punkte 1 bis 16, wobei mindestens ein Adapter mit einer Messeinrichtung zur Bestimmung des Widerstandes, der Induktivität, Spannung und/oder der Kapazität eines daran angeschlossenen elektrischen Leiters des Kabelbaums verbunden oder versehen ist.
Punkt 18: einen Tisch nach einem der Punkte 1 bis 17, wobei mindestens ein Adapter zur Bestimmung der Signaldämpfung eines Lichtwellenleiters des Kabelbaums vorhanden ist.
Punkt 19: einen nach einem der Punkte 1 bis 18, wobei die Steckplatte aus mehreren Steckmodulen zusammengesetzt ist und durch Anfügen und/oder Entnehmen weiterer Steckmodule nach Bedarf in Längs- und/oder Querrichtung vergrösserbar und/oder verkleinerbar ist.
Punkt 20: einen Tisch nach Punkte 19, wobei die Steckmodule quadratisch, rautenförmig oder sechseckig begrenzt sind.
Punkt 21: einen Tisch nach einem der Punkte 1 bis 20, umfassend einen modulartig aufgebauten Bausatz aus zumindest einer Grundplatte, einem Adapter und einem Steckmodul, die zur geometrisch korrekten Verlegung, Montage und Prüfung eines Kabelbaums nach Bedarf computergesteuert zusammensteckbar und voneinander lösbar sind.
Punkt 22: einen Tisch nach einem der Punkte 1 bis 21, wobei sich mindestens zwei Signalleiter (N, O, P, Q, R, S) mit verschiedenen elektrischen Potentialen kreuzen.
Punkt 23: Verwendung des Tisches nach einem der Punkte 1 bis 22 bei der Montage und Prüfung von von Kabelbäumen abweichenden Prüflingen.

### Kurzbeschreibung der Zeichnung

Eine beispielhafte Ausführung der Erfindung ist in der beiliegenden Zeichnung dargestellt. Sie wird nachfolgend näher erläutert.

Es zeigen:
Fig. 1 einen mit fünf Adaptern bestückten Tisch bei der Verlegung und/oder Prüfung eines Kabelbaums
Fig. 2 den funktionellen Aufbau eines Tisches oder einer Steckplatte oder eines Steckmoduls in schematischer Darstellung
Fig. 3 die Anordnung der Schalter, die es ermöglichen, die Position der Adapter zu erkennen
Fig. 4 bis 10 einige beispielhafte Potenzialbelegungen von Steckmodulen.

### Ausführung der Erfindung

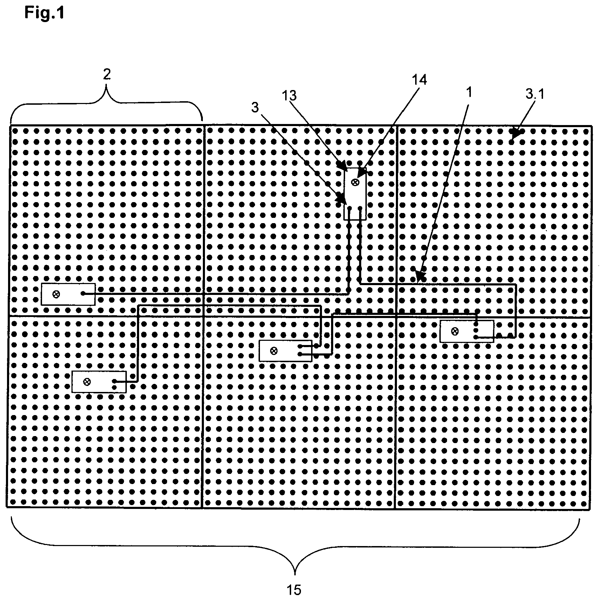

Der in Fig. 1 gezeigte Tisch besteht aus einer Grundplatte und einer darauf angebrachten Steckplatte 15, die aus sechs Steckmodulen 2 von rechteckiger Gestalt zusammengesetzt ist und eine Vielzahl von elektrisch gegeneinander isolierten Kontaktelementen 3.1 aufweist, auf denen fünf Adapter 13 durch Einfügen der daran befestigten Stecker in die Kontaktelemente 3.1 fixiert sind, die als Kontaktbuchsen ausgebildet sind. Der Tisch ist in diesem Falle für die Verlegung und/oder Prüfung eines Kabelbaums 1 bestimmt. Auf den Kontaktbuchsen 3.1 werden die Adapter 13 sechspolig durch Aufstecken kontaktiert. Jeder Adapter 13 enthält eine beliebige Anzahl von Gegensteckern 3, vorliegend einen bis zu drei, die eine Verbindung mit den Kabelenden des zu prüfenden Kabelbaums herstellen, sowie eine Leuchtdiodenanzeige 14. Die Gegenstecker 3 sind zur geometrisch korrekten Belegung mit den in einem Kabelbaum 1 enthaltenen Kabeln von einem Computer gesteuert, paarweise aufeinanderfolgend durch die Leuchtdiodenanzeigen 14 markierbar, wobei eine Messeinrichtung vorgesehen ist, die bei korrekter Belegung eines jeden Paares von durch ein Kabel verbundenen Gegensteckern 3 eine Umschaltung der Leuchtdiodenanzeige 14 zu dem nächstfolgenden Paar zu belegender Gegenstecker 3 der Adapter 13 bewirkt.

Die Adapter 13 sind in zwei verschiedenen Ausrichtungen an zuvor frei ausgewählten Stellen auf die Steckplatte 15 aufgesteckt und dabei zugleich mit mehreren Kontaktelementen 3.1 signal- und/oder stromleitend verbunden. In Abhängigkeit von der Art und Größe des jeweils herzustellenden Kabelbaums wird die korrekte Positionierung der Adapter 13 auf den Steckmodulen 2 und die Positionierung der Steckmodule 2 auf der Grundplatte jeweils computergesteuert angezeigt. Die Auswahl hängt dabei von der Art der jeweils durchzuführenden Messung ab und kann ebenfalls computergesteuert angegeben werden.

Im Anschluss daran erfolgt computergestützt die jeweils durchzuführende Belegung mit den Kabeln des Kabelbaums 1, woran sich die Prüfung der Kabel anschließen kann.

Die Steckplatte 15 ist aus den Steckmodulen 2 zusammengesetzt und durch Anfügen und/oder Entnehmen weiterer Steckmodule 2 nach Bedarf in Längs- und/oder Querrichtung vergrößerbar und/oder verkleinerbar. Sie muss keinen rechteckigen oder quadratischen äußeren Umriss haben, sondern sie kann so gestaltet werden, dass ein herzustellender oder zu prüfender Kabelbaum besonders bequem aufbaubar ist. Da die darin enthaltenen Kabel flexibel sind, genügt die korrekte Ausbildung und Messung. Es ist hingegen nicht erforderlich, dem Kabelbaum 1 bereits bei seiner Herstellung die Gestalt der Einbauform zu geben.

Der Tisch kann somit aus einem modulartig aufgebauten Bausatz aus zumindest einem Adapter 13, einem Steckmodul 2 und einer Grundplatte bestehen, die zur geometrisch korrekten Verlegung und/oder Prüfung eines Kabelbaums 1 nach Bedarf computergesteuert zusammensteckbar und voneinander lösbar sind. Es kann auch nur ein Adapter 13 auf einer Steckplatte 15 montiert sein.

Die Anschlußelemente der Adapter 13 an die Kontaktelemente 3.1 werden nachfolgend immer als Kontaktfelder bezeichnet.

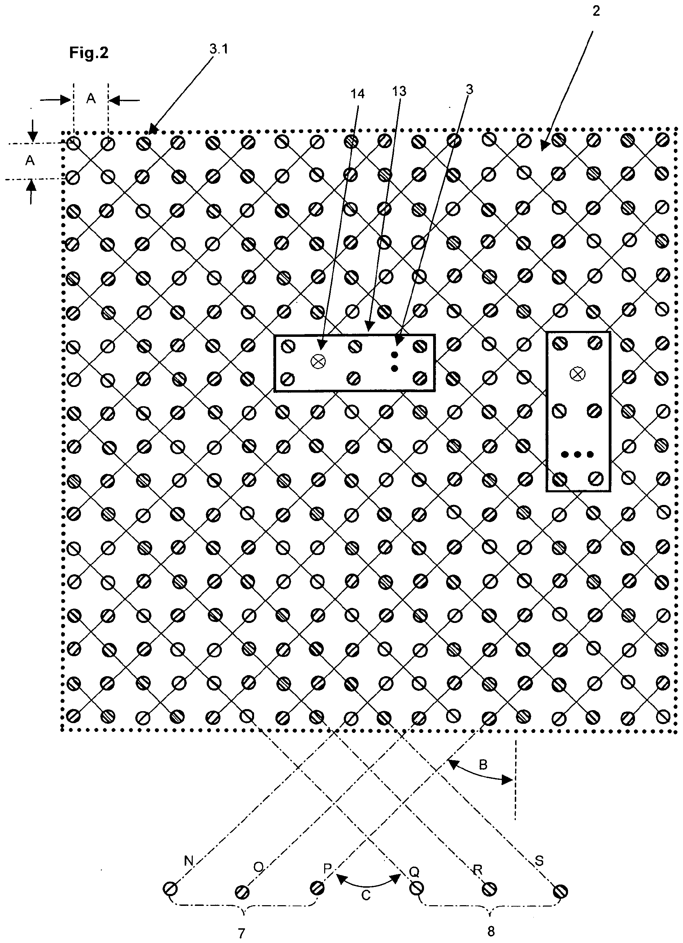

Fig. 2 ist der funktionelle Aufbau eines Tisches in schematischer Darstellung wiedergegeben. Es wird gezeigt, dass alle übereinstimmend geschalteten Kontaktelemente 3.1 im Zuge von diagonal verlaufenden Signalleiterscharen von parallel verlaufenden Signalleitern N, O, P und Q, R, S angeordnet sind, die die Signalleitergruppen 7 und 8 bilden, einander überkreuzen und zugleich die Lage der Kontaktelemente 3.1 bestimmen, mit denen sie signalleitend verbunden sind. Die Kontaktelemente 3.1 sind in einem wiederkehrenden, quadratischen Grundraster der Teilung A angeordnet. Übereinstimmende Potenzialbelegungen der Kontaktelemente 3.1 sind übereinstimmend graphisch gemustert und markiert.

Die Kontaktelemente 3.1 sind auf der Steckplatte in einem quadratischen Kontaktelementmuster A verteilt, das in horizontaler und vertikaler Richtung regelmäßig wiederkehrend aufeinander folgt, wobei die Kontaktelemente 3.1 durch mehrere elektrisch gegeneinander isolierte Signalleiter N, O, P, Q, R, S mit verschiedenen elektrischen Potentialen belegt sind, wobei sich mindestens zwei Signalleiter N, O, P, Q, R, S mit verschiedenen elektrischen Potentialen kreuzen, wobei jeder Adapter 13 mit allen Potenzialen zumindest einmal verbunden ist, einen Identifizierungscode und eine interne Steuerung besitzt, die eine Entnahme von Versorgungsstrom aus den Signalleitern N, O, P, Q, R, S und deren Identifizierung bewirkt und die geeignet ist, mit einem Rechner und/oder einem anderen Adapter 13 zu kommunizieren, wobei die Steckplatte 15 und/oder der Adapter 13 und/oder ein externer Rechner, jeder für sich und/oder im Zusammenspiel miteinander, erste Mittel umfassen, die eine Erkennung der jeweiligen Position des Adapters 13 auf der Steckplatte 15 bewirken, wobei die elektrischen Potentiale an den Kontaktelementen 3.1 in einem Potentialmuster verteilt sind, das in horizontaler und vertikaler Richtung regelmäßig wiederkehrend folgt und wobei jeder Adapter 13 mit dem Prüfling 1 in Eingriff bringbar ist und zweite Mittel umfasst, die die Montage und/oder die Prüfung des Prüflings 1 unterstützen und/oder bewirken.

Die Kontaktelemente 3.1 sind durch die Gruppen 7, 8 aus parallel verlaufenden Signalleitern N, O, P; Q, R, S ansteuerbar, die der Ausrichtung des Kontakelementmusters unter einem Winkel B von 45 ° und einander unter einem Winkel C von 90 ° zugeordnet sind, wobei alle Signalleiter N, 0, P, Q, R, S der beiden Gruppen 7, 8 mit von einander verschiedenen Potenzialen belegt sind, wobei die Potenzialbelegung der Signalleiter N, O, P sowie Q, R, S innerhalb der beiden Gruppen 7, 8 regelmäßig wiederkehrend wechselt.

Die Anzahl der jeweils in den Gruppen 7, 8 enthaltenen Signalleiter N, O, P, Q, R, S beträgt bei dem gezeigten Ausführungsbeispiel, das im Rahmen der Erfindung bevorzugt wird, sechs, wobei die Signalleiter N, O, P dem Grundraster der Buchsen 3.1 rechtsgeneigt zugeordnet sind und die Signalleiter Q, R, S den Buchsen 3.1 linksgeneigt jeweils unter einem Winkel von 45°.

Von den Adaptern 13 sind auch in Fig. 2 jeweils nur die Umrisse und die Kontaktfelder gezeigt, die mit den Kontaktelementen 3.1 der Steckmodule 2 in Kontakteingriff bringbar sind. Die Adapter 13 sind dabei parallel zueinander durch jeweils sechs Kontaktfelder mit den Steckmodulen 2 verbindbar, die paarweise nebeneinanderliegend angeordnet sind. Es ist zu erkennen, dass nach dem

Aufstecken der Adapter 13 auf die Steckmodule 2 in jedem der Kontaktfelder eines jeden Adapters 13 ein von den übrigen Kontaktfeldern verschiedener Signaleiter N, O, P, Q, R, S sichtbar wird. Damit sind alle Signale der Signalleiter N, O, P, Q, R, S unabhängig von der jeweiligen Anbringungsposition des jeweiligen Adapters 13 für jeden der Adapter 13 unmittelbar verfügbar.

Die Adapter 13 sind mit Signalleuchten 14 versehen sowie mit einer unterschiedlichen Anzahl von Gegenkontakten 3, die dazu dienen, Prüflinge anzuschließen. Die Adapter 13 sind so dimensioniert und gestaltet, dass alle Potenziale der Signalleiter N, O, P, Q, R, S darin verfügbar sind.

Es ist ferner zu erkennen, dass die Adapter 13 nur mit einer horizontalen oder vertikalen Ausrichtung auf die Buchsen 3.1 aufsteckbar sind, nicht jedoch mit einer diagonal links- bzw. rechts geneigten Ausrichtung. Fehlbelegungen wird dadurch vorgebeugt.

Die Signalleiter N, O, P, Q, R, S umfassen bei dem gezeigten Ausführungsbeispiel zwei Signalleiter N, O, P, Q, R, S die die Funktion eines Kommunikations - Busses haben. Sie ermöglichen es, jeden Adapter 13 richtig zu positionieren und anzusteuern.

Ferner umfassen die Signalleiter N, O, P, Q, R, S zwei Signalleiter N, O, P, Q, R, S die die Funktion eines Mess - Leitung haben. Damit ist es möglich, eine vorgeschriebene Messung des angeschlossenen Kabels und eines anderen Prüflings durchzuführen.

Die Signalleiter N, O, P, Q, R, S umfassen außerdem zwei Signalleiter N, O, P, Q, R, S die die Funktion der Stromversorgung des jeweiligen Adapters 13 sicherstellen und dadurch die Inbetriebnahme und Verwendung der enthaltenen Steuerung.

Dabei kann mindestens ein Adapter 13 mit einer Messeinrichtung zur Bestimmung des Widerstandes oder der Kapazität eines daran angeschlossenen elektrischen Leiters des Kabelbaums vorgesehen sein und/oder mindestens ein Adapter 13 zur Bestimmung der Signaldämpfung eines Lichtwellenleiters in dem Kabelbaum. Die Messeinrichtung wird zu diesem Zweck über zwei Signalleiter und die in den Adaptern befindlichen Schalter der Schaltermatrix mit dem Prüfling verbunden.

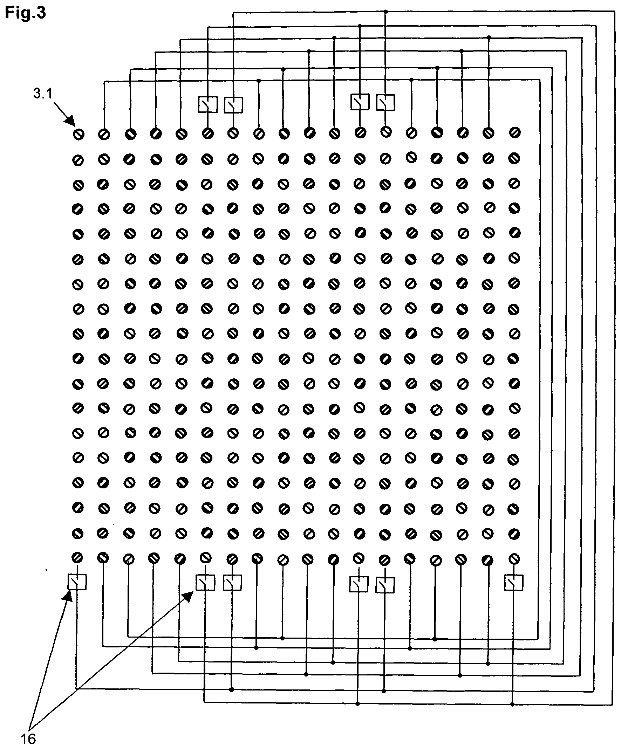

Fig. 3 zeigt, dass die aufeinander folgenden, übereinstimmenden Signalleiter N, O, P, Q, R, S durch Schalter 16 schaltbar sind. Durch die aufeinanderfolgende Aktivierung der einander überkreuzenden Signalleiter N, O, P, Q, R, S, die analog Fig. 2 verlaufend angeordnet sind, lässt sich so in Verbindung mit der Steuerung und dem Identifizierungscode der aufgesteckten Adapter herausfinden, an welcher geometrischen Stelle der Steckplatte sich der jeweilige Adapter befindet. Die Stelle kann bei Bedarf computergesteuert rekonstruiert werden, wie oben angegeben. Die Ausrichtung kann an Hand der Signalbelegung durch den Adapter ermittelt und einem Rechner übermittelt werden. Darin sind die Daten rekonstruierbar abspeicherbar. Übereinstimmende Potenzialbelegungen der Kontaktelemente 3.1 sind analog Fig. 2 übereinstimmend graphisch gemustert und markiert.

Das gleiche System lässt sich auch bei der Positionierung der Steckmodule auf der nicht dargestellten Grundplatte verwenden.

Nachfolgend werden einige Potenzialmuster X1, X2, X3, X4, X5, X6, X7 beschrieben, mit denen die Kontaktelemente 3.1 belegt sein können. Die Potenziale wurden dabei aus Gründen der besseren Anschaulichkeit mit den Ziffern 1 bis 6 belegt, die Signalleiter mit den Buchstaben N, O, P, Q, R, S.

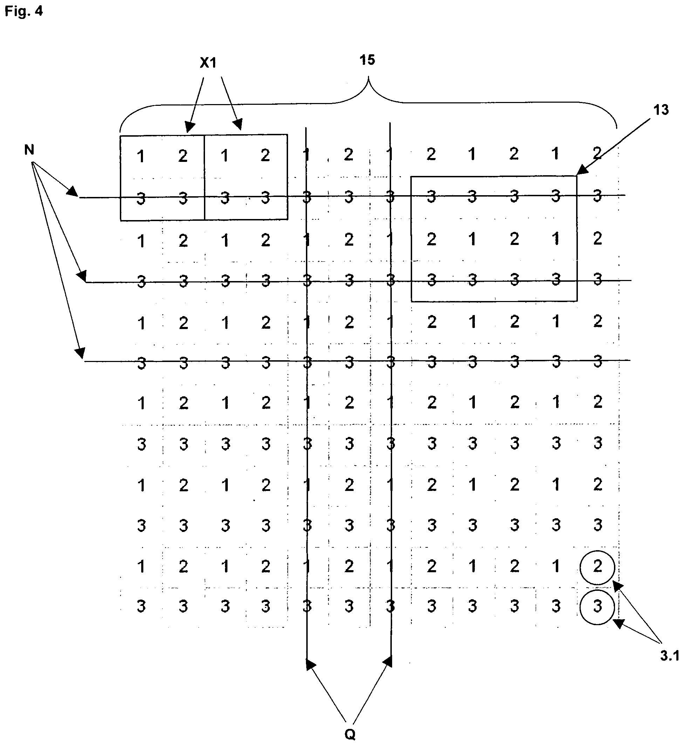

Fig. 4 zeigt ein erstes Beispiel, nach dem die Kontaktelemente 3.1 mit einem rechteckigen Potenzialmuster X1 belegt sind, wobei in der ersten Zeile des Potenzialmusters X1 wenigstens zwei von einander verschiedene, regelmäßig wiederkehrend aufeinanderfolgende Potenziale 1, 2 vorgesehen sind und in der zweiten Zeile nur ein zweites regelmäßig wiederkehrendes Potenzial 3. In dem Adapter 13 sind unabhängig von der Anbringungsposition und Ausrichtung alle Potenziale 1 bis 3 verfügbar. Er ist dadurch funktionsfähig und verwendbar.

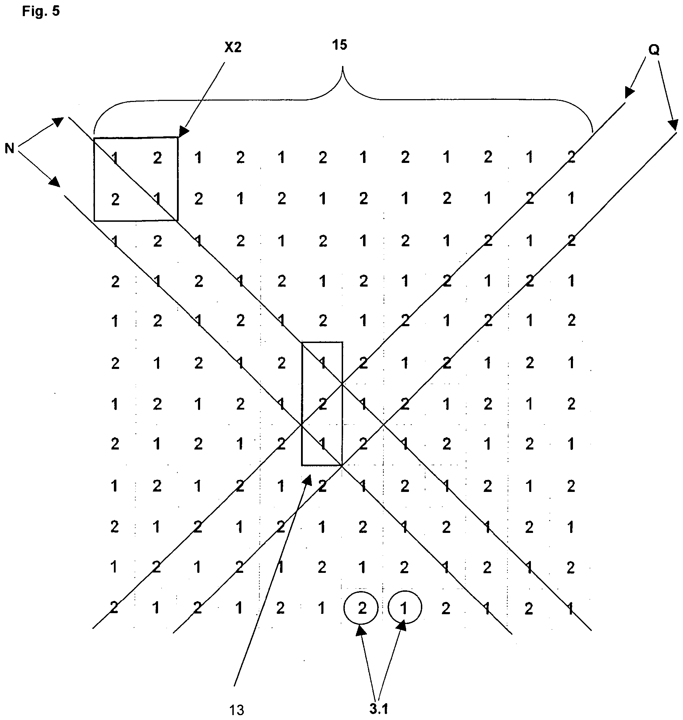

Fig. 5 zeigt Kontaktelemente 3.1, die mit einem rechteckigen Potenzialmuster X2 belegt sind, das in der ersten und zweiten Zeile wenigstens zwei voneinander verschiedene, regelmäßig wiederkehrend aufeinanderfolgende, erste Potenziale 1, 2 umfasst mit der Maßgabe, dass die Potenziale 1, 2 in der ersten und zweiten Zeile in umgekehrter Richtung aufeinander folgen. In einem beispielhaften Adapter 13 sind drei in einer Reihe hintereinander angeordnete Kontaktfelder angeordnet. Sie stellen unabhängig von der Anbringungsposition und Ausrichtung alle vorhandenen Potenziale 1, 2 für die interne Steuerung zur Verfügung.

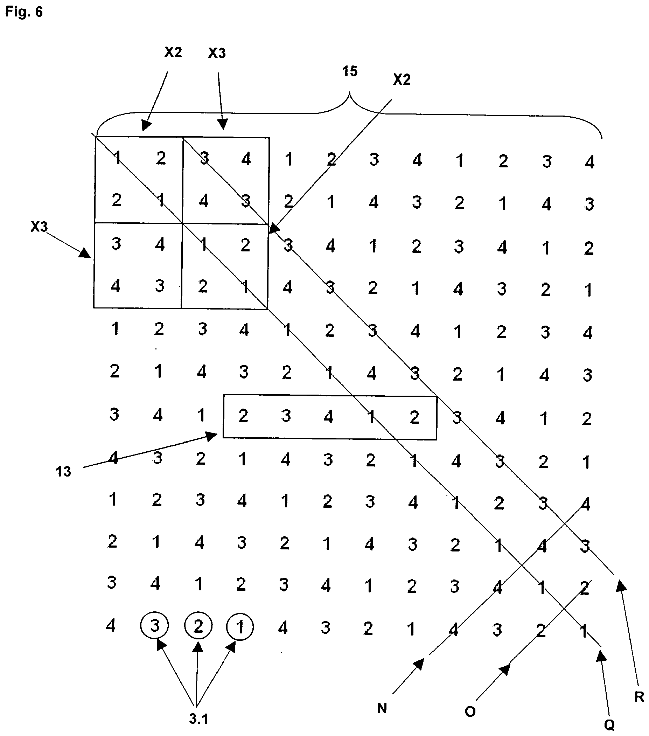

Fig. 6 zeigt einen Tisch bei dem die Kontaktelemente 3.1 mit zwei von einander verschiedenen, quadratischen Potenzialmustern X2, X3 belegt sind, die sich horizontal und vertikal regelmäßig abwechselnd wiederholen, wobei das Potenzialmuster X2, X3 jeweils vier Potenziale umfasst, die einander diagonal gegenüberliegend mit identischen und, bezogen auf einander, mit verschiedenen Potenzialen belegt sind. In einem beispielhaften Adapter 13 sind fünf in einer Reihe hintereinander angeordnete Kontaktfelder angeordnet. Sie stellen unabhängig von der Anbringungsposition und Ausrichtung alle vorhandenen Potenziale 1, 2, 3, 4 für die interne Steuerung zur Verfügung.

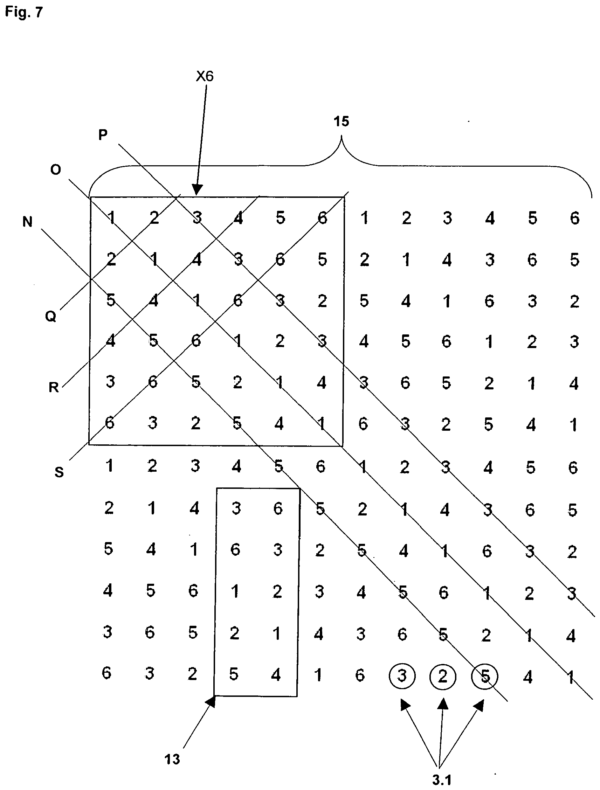

Fig. 7 zeigt einen Tisch bei dem die Kontaktelemente 3.1 mit einem einheitlichen Potenzialmuster X6 belegt sind. Das Potenzialmuster X6 ist im Verlauf von geradlinig verlaufenden Signalleitern N, O, P, Q, R und S angeordnet, die sich innerhalb von einander überkreuzenden Signalleitergruppen parallel zu einander erstrecken und gegenseitig unter einem Winkel von 90° überkreuzen. Die Signalleiter N, O, P, Q, R und S folgen dabei innerhalb der Signalleitergruppen und die Signalleitergruppen innerhalb von Signalleiterscharen, die gleichmäßig über die gesamte Steckplatte 15 verteilt angeordnet sind, regelmäßig wiederkehrend aufeinander.

In dem Potenzialmuster X6 sind in horizontaler und vertikaler Richtung jeweils sechs Potenziale 1 - 6 vorhanden. Die Zahl kann in Abhängigkeit vom jeweiligen Verwendungszweck vergrößert oder verkleinert werden. Der jeweils zugehörige Adapter 13 ist so gestaltet, dass alle verfügbaren, hier alle sechs Potenziale, zumindest einmal durch Kontaktfelder angeschlossen und erfasst werden.

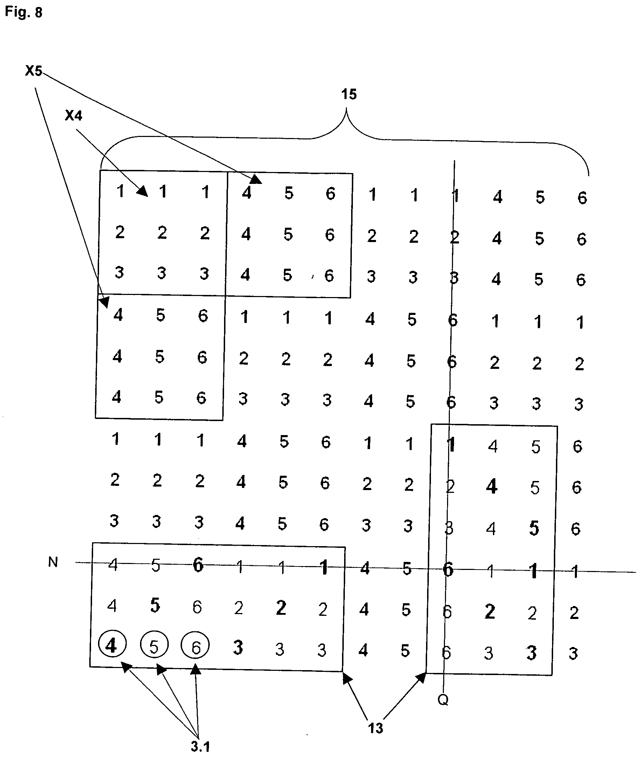

Fig. 8 zeigt einen Tisch, bei dem die Kontaktelemente 3.1 mit zwei von einander verschiedenen, quadratischen Potenzialmustern X4, X5 belegt sind, die sich horizontal und vertikal regelmäßig abwechselnd wiederholen, wobei die in dem Potenzialmuster X4 enthaltenen, horizontal nebeneinander liegenden Kontaktelemente 3.1 mit identischen und die vertikal übereinanderliegenden Kontaktelemente 3.1 mit verschiedenen Potenzialen 1 - 6 belegt sind, wobei die in dem Potenzialmuster X5 enthaltenen, vertikal übereinander liegenden Kontaktelemente 3.1 mit identischen und die horizontal nebeneinander liegenden Kontaktelemente 3.1 mit verschiedenen Potenzialen belegt sind und wobei die Potenziale der Potenzialmuster X4 und X5 voneinander verschieden sind. Die Kontaktfelder der Adapter 13 stellen unabhängig von der Anbringungsposition und Ausrichtung jeweils alle vorhandenen Potenziale 1, 2, 3, 4, 5, 6 für die interne Steuerung zur Verfügung. Es wurden nur zwei einander überkreuzende Signalleiter N, Q repräsentativ für die insgesamt sechs vorhandenen Signalleiter N, O, P, Q, R und S eingetragen.

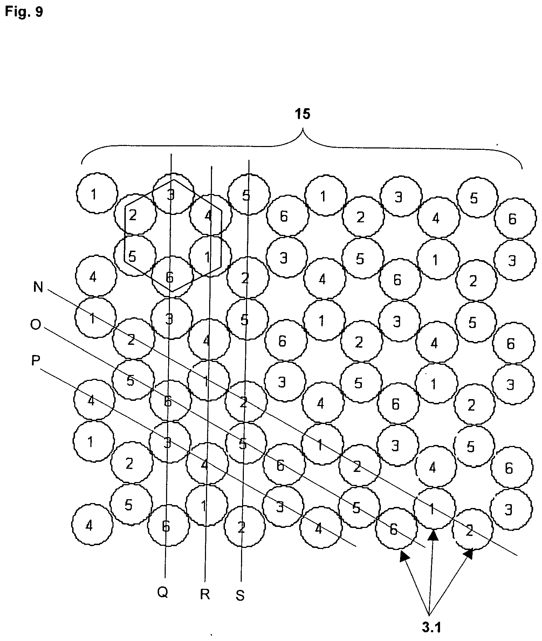

Fig. 9 zeigt einen Tisch, bei dem jeweils sechs Kontaktelemente 3.1 in einem Kontaktelementmuster zusammengefasst sind, das die Gestalt eines gleichseitigen Sechsecks hat und sich horizontal und vertikal nach Art einer Bienenwabe wiederholt. Die Kontaktelemente folgen dabei innerhalb der Struktur des gezeigten Sechsecks so aufeinander, dass unabhängig von der Anbringungspositon eines Adapters immer alle sechs Potenziale 1 bis 6 verfügbar sind. Diese werden über Signalleiter N, O und P und sich damit überkreuzende Signalleiter Q, R und S zugeführt, die jeweils eine Gruppe bilden und innerhalb der Gruppen parallel zueinander verlaufen und regelmäßig wiederkehrend aufeinander folgen. Auch hierbei bilden die Gruppen Bestandteile von einander überkreuzenden Signalleiterscharen, die gleichmäßig über die ganze Steckplatte verteilt sind. Sie können auch Bestandteile von gedruckten Schaltungen bilden, die hinter der Steckplatte 15 angeordnet sind. Die Kontaktfelder der Adapter 13 stellen dabei auch unabhängig von der Anbringungsposition jeweils alle vorhandenen Potenziale 1 bis 6 für die interne Steuerung zur Verfügung.

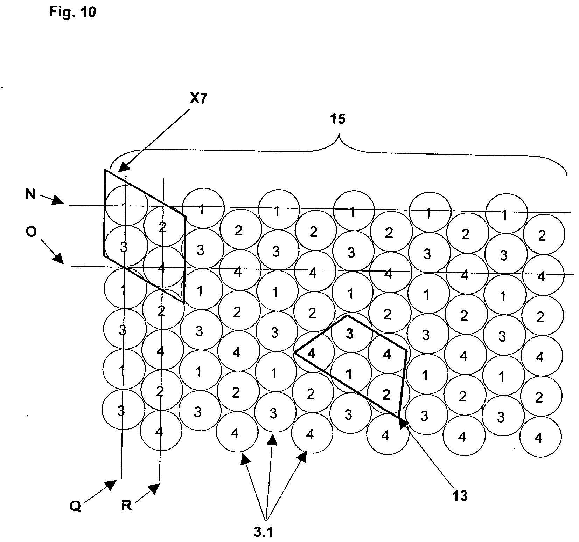

Fig. 10 zeigt einen Tisch, bei dem jeweils vier Kontaktelemente 3.1 in einem Potenzialmuster derart zusammengefasst sind, dass die Kontaktelemente 3.1 auf der Steckplatte 15 in einem sich horizontal und vertikal regelmäßig wiederholenden, rautenförmigen Potentialmuster X7 verteilt und einander derart auf Lücke zugeordnet sind, dass sich die Grundstruktur eines gleichseitigen Dreiecks ergibt. Die Adapter 13 sind wiederum so dimensioniert und gestaltet, dass alle Potenziale 1 - 4 wenigstens einmal für die interne Steuerung verfügbar sind. Sie werden über Signalleiter N, O; Q, R zugeführt, die paarweise einander überkreuzen, sich innerhalb der Paare parallel zueinander erstrecken und Bestandteile von Signaleiterscharen bilden, die gleichmäßig über die ganze Steckplatte verteilt sind. Die Kontaktfelder der Adapter 13 stellen dabei auch unabhängig von der Anbringungsposition jeweils alle vorhandenen Potenziale 1 bis 4 für die interne Steuerung zur Verfügung.

## Patentansprüche

1. Tisch für die Montage und Prüfung eines Prüflings (1), bestehend aus zumindest einer Steckplatte (15) mit einer Vielzahl von elektrisch gegeneinander isolierten Kontaktelementen (3.1) und mindestens einem modulartigen Adapter (13), der eine Vielzahl von Anschlusselementen aufweist, um in zumindest einer Ausrichtung an jeder von einer Vielzahl von beliebigen Positionen der Steckplatte (15) anordenbar zu sein, so dass der Adapter (13) in jeder der Anordnungen über die Anschlusselemente zugleich mit wenigstens zwei Kontaktelementen (3.1) in der jeweiligen Anordnung leitend verbindbar ist, wobei die Anordnung durch die Ausrichtung und die Position definiert ist, an welcher der Adapter angeordnet ist,
wobei bei jeder der Anordnungen durch ein Aufstecken des Adapters (13) auf die Steckplatte eine leitende Verbindung des Adapters mit den jeweiligen wenigstens zwei Kontaktelementen (3.1) herstellbar ist,
wobei der Tisch so konfiguriert ist,
dass die Kontaktelemente (3.1) in einem Kontaktelementmuster verteilt sind, das in einer horizontalen und einer vertikalen Richtung regelmäßig wiederkehrend aufeinander folgt, wobei die horizontale Richtung und die vertikale Richtung parallel zur Steckplatte sind;
wobei jedes der Kontaktelemente (3.1) jeweils mit einem von wenigstens zwei elektrisch gegenseitig isolierten Signalleitern des Tisches verbunden ist, so dass die Kontaktelemente durch die wenigstens zwei Signalleiter (N, O, P, Q, R, S) mit verschiedenen elektrischen Potentialen (1-6) belegt sind, und so dass die verschiedenen elektrischen Potentiale (1 - 6) an den Kontaktelementen (3.1) in wenigstens einem Potentialmuster (X1, X2, X3, X4, X5, X6, X7) verteilt sind, das in der horizontalen und in der vertikalen Richtung regelmäßig wiederkehrend folgt,
dass der Adapter (13) in jeder der Anordnungen durch die leitende Verbindung mit den jeweiligen wenigstens zwei Kontaktelementen mit allen Potenzialen zumindest einmal verbindbar ist, wobei in jeder der Anordnungen die Potenziale (1-6) eine Potenzialbelegung der Anschlusselemente erzeugen, welche abhängig ist von der Anordnung des Adapters;
dass der Adapter (13) einen Identifizierungscode besitzt,
dass der Adapter (13) eine interne Steuerung besitzt, die in jeder der Anordnungen nach dem Verbinden mit den wenigstens zwei Kontaktelementen in der jeweiligen Anordnung eine Entnahme von Versorgungsstrom aus den Signalleitern (N, O, P, Q, R, S) bewirkt,
dass die Steuerung eine Schaltung aufweist zur Identifizierung der Signalleiter, welche mit den Anschlusselementen verbunden sind, und zur Herstellung einer richtigen Verbindung des Adapters mit sämtlichen Potenzialen der Signalleiter, so dass alle Potenziale der Signalleiter unabhängig von der jeweiligen Anordnung des Adapters für den Adapter verfügbar sind;
wobei die Steuerung konfiguriert ist, mit einem Rechner und/oder einem anderen Adapter (13) zu kommunizieren,
dass die Steckplatte (15) und/oder der Adapter (13) und/oder ein externer Rechner, jeder für sich und/oder im Zusammenspiel miteinander, erste Mittel umfassen, die eine Erkennung der jeweiligen Position des Adapters (13) auf der Steckplatte (15) bewirken,
dass jeder Adapter (13) mit dem Prüflinge (1) in Eingriff bringbar ist und Mittel umfasst, die die Montage und die Prüfung des Prüflings (1) unterstützen und/oder bewirken.

2. Tisch nach Anspruch 1, **dadurch gekennzeichnet, dass** die Signalleiter (N, O, P, Q, R, S) zwei Signalleiter (N, O, P, Q, R, S) umfassen, die die Funktion eines Kommunikations-Busses haben.

3. Tisch nach Anspruch 1 oder 2, **dadurch gekennzeichnet, dass** die Signalleiter (N, O, P, Q, R, S) zwei Signalleiter (N, O, P, Q, R, S) umfassen, die die Funktion einer Mess-Leitung haben.

4. Tisch nach einem der vorangehenden Ansprüche, **dadurch gekennzeichnet, dass** die Signalleiter (N, O, P, Q, R, S) zwei Signalleiter (N, O, P, Q, R, S) umfassen, die die Funktion der Stromversorgung des jeweiligen Adapters (13) haben.

5. Tisch nach einem der vorangehenden Ansprüche, **dadurch gekennzeichnet, dass** die Steckplatte (15) aus mehreren Steckmodulen (2) zusammengesetzt ist und durch Anfügen und/oder Entnehmen weiterer Steckmodule (2) nach Bedarf in Längs- und/oder Querrichtung vergrößerbar und/oder verkleinerbar ist.

6. Tisch nach Anspruch 5, **dadurch gekennzeichnet, dass** die Steckmodule (2) quadratisch, rautenförmig oder sechseckig begrenzt sind.

7. Tisch nach einem der vorangehenden Ansprüche, umfassend einen modulartig aufgebauten Bausatz aus zumindest einer Grundplatte, einem Adapter (13) und einem Steckmodul (2), die zur geometrisch korrekten Verlegung, Montage und Prüfung eines Kabelbaums (1) nach Bedarf computergesteuert zusammensteckbar und voneinander lösbar sind.

## Claims

1. Table for mounting and testing a test specimen (1), consisting of at least one plug-in board (15) with a large number of contact elements (3) which are electrically insulated from each other, and of at least one modular adapter (13) having a plurality of connecting elements to be capable of being arranged in at least one alignment at each of a plurality of arbitrary positions of the plug-in board (15), such that the adapter (13) can be connected in each of the arrangements via the connecting elements simultaneously to at least two contact elements (3.1) of the respective arrangement in a conductive manner, wherein the arrangement being defined by the alignment and the position at which the adapter is arranged,
wherein a conductive connection of the adapter with the respective at least two contact elements (3.1) can be produced in each of the arrangements by plugging the adapter (13) onto the plug-in plate,
wherein the table is configured in such a manner
that the contact elements (3.1) are distributed in a contact element pattern which regularly follows one another in a horizontal and a vertical direction, wherein the horizontal direction and the vertical direction being parallel to the plug-in board;
wherein each of the contact elements (3.1) being connected to one of at least two electrically mutually insulated signal conductors of the table so that the contact elements are occupied by the at least two signal conductors (N, O, P, Q, R, S) with different electrical potentials (1-6), and so that the different electrical potentials (1-6) are distributed on the contact elements (3.1) in at least one potential pattern (X1, X2, X3, X4, X5, X6, X7) which regularly repeats in the horizontal and vertical direction,
that the adapter (13) can be connected to all potentials at least once in each of the arrangements by the conductive connection to the respective at least two contact elements, wherein in each of the arrangements the potentials (1-6) generate a potential assignment of the connection elements, which depends on the arrangement of the adapter;
that the adapter (13) has an identification code,
that the adapter (13) has an internal control system which causes in each of the arrangements, after connection to the at least two contact elements in the respective arrangement, a withdrawal of supply current from the signal conductors (N, O, P, Q, R, S) in the respective arrangement,
that the controller comprises a circuit for identifying the signal conductors connected to the connecting elements and for establishing a correct connection of the adapter to all potentials of the signal conductors, so that all potentials of the signal conductors are available for the adapter regardless of the respective arrangement of the adapter;
wherein the controller being configured to communicate with a computer and/or another adapter (13),
that the plug-in board (15) and/or the adapter (13) and/or an external computer, each for itself and/or in interaction with one another, comprise first means for detecting the respective position of the adapter (13) on the plug-in board (15),
that each adapter (13) can be brought into contact with the test specimen (1) and comprises means which support and/or effect the assembly and testing of the test specimen (1).

2. Table according to claim 1, **characterized in that** the signal conductors (N, O, P, Q, R, R, S) comprise two signal conductors (N, O, P, Q, R, S) which have the function of a communication bus.

3. Table according to claim 1 or 2, **characterized in that** the signal conductors (N, O, P, Q, R, R, S) comprise two signal conductors (N, O, P, Q, R, S) which have the function of a measuring line.

4. Table according to one of the preceding claims, **characterized in that** the signal conductors (N, O, P, Q, R, R, S) comprise two signal conductors (N, O, P, Q, R, S) which have the function of the power supply of the respective adapter (13).

5. Table according to one of the preceding claims, **characterized in that** the plug-in board (15) is composed of a plurality of plug-in modules (2) and can be enlarged and/or reduced in size as required by adding and/or removing of further plug-in modules (2) in the longitudinal and/or transverse direction.

6. Table according to one of the preceding claims, **characterized in that** the plug-in modules (2) are limited to square, diamond-shaped or hexagonal.

7. Table according to one of the preceding claims, comprising a modularly constructed assembly of at least one base plate, an adapter (13) and a plug-in module (2) which can be computer-controlled connected together and detached from each other as required for geometrically correct laying, mounting and testing of a wiring harness (1).

## Revendications

1. Table pour le montage et la vérification d'un échantillon (1), constituée d'au moins une plaque d'enfichage (15) avec une pluralité d'éléments de contact (3.1) mutuellement isolés électriquement et d'au moins un adaptateur (13) modulaire qui présente une pluralité d'éléments de raccordement afin de pouvoir être agencé dans au moins une orientation sur chacune d'une pluralité de positions quelconques de la plaque d'enfichage (15) de sorte que l'adaptateur (13) puisse être relié par conduction dans chacun des agencements par le biais des éléments de raccordement en même temps à au moins deux éléments de contact (3.1) dans l'agencement respectif, dans laquelle l'agencement est défini par l'orientation et la position dans laquelle l'adaptateur est agencé,
dans laquelle pour chacun des agencements par un enfichage de l'adaptateur (13) sur la plaque d'enfichage une liaison conductrice de l'adaptateur peut être établie avec les au moins deux éléments de contact (3.1) respectifs,
dans laquelle la table est configurée de sorte
que les éléments de contact (3.1) soient répartis dans un motif d'éléments de contact qui s'enchaîne dans une direction horizontale et une direction verticale en se répétant régulièrement, dans laquelle la direction horizontale et la direction verticale sont parallèles à la plaque d'enfichage ;
dans laquelle chacun des éléments de contact (3.1) est respectivement relié à un d'au moins deux conducteurs de signal mutuellement isolés électriquement de la table, de sorte que les éléments de contact soient occupés par les au moins deux conducteurs de signal (N, O, P, Q, R, S) avec différents potentiels électriques (1-6), et de sorte que les différents potentiels électriques (1-6) soient répartis sur les éléments de contact (3.1) dans au moins un motif de potentiels (X1, X2, X3, X4, X5, X6, X7) qui suit dans la direction horizontale et la direction verticale en se répétant régulièrement,
que l'adaptateur (13) puisse être relié au moins une fois dans chacun des agencements par la liaison conductrice avec les au moins deux éléments de contact respectifs à tous les potentiels, dans laquelle les potentiels (1-6) génèrent dans chacun des agencements une occupation de potentiel des éléments de raccordement, laquelle dépend de l'agencement de l'adaptateur ;
que l'adaptateur (13) possède un code d'identification,
que l'adaptateur (13) possède une commande interne qui provoque dans chacun des agencements après la liaison avec les au moins deux éléments de contact dans l'agencement respectif un prélèvement de courant d'alimentation des conducteurs de signal (N, O, P, Q, R, S),
que la commande présente un circuit pour l'identification des conducteurs de signal qui sont reliés aux éléments de raccordement, et pour l'établissement d'une véritable liaison de l'adaptateur avec tous les potentiels des conducteurs de signal, de sorte que tous les potentiels des conducteurs de signal soient disponibles pour l'adaptateur indépendamment de l'agencement respectif de l'adaptateur ;
dans laquelle la commande est configurée afin de communiquer avec un ordinateur et/ou un autre adaptateur (13),
que la plaque d'enfichage (15) et/ou l'adaptateur (13) et/ou un ordinateur externe comprennent, chacun pour soi et/ou en interaction les uns avec les autres, de premiers moyens qui provoquent une reconnaissance de la position respective de l'adaptateur (13) sur la plaque d'enfichage (15),
que chaque adaptateur (13) puisse être mis en prise avec l'échantillon (1) et comprenne des moyens qui soutiennent et/ou provoquent le montage et la vérification de l'échantillon (1).

2. Table selon la revendication 1, **caractérisée en ce que** les conducteurs de signal (N, O, P, Q, R, S) comprennent deux conducteurs de signal (N, O, P, Q, R, S) qui assurent la fonction d'un bus de communication.

3. Table selon la revendication 1 ou 2, **caractérisée en ce que** les conducteurs de signal (N, O, P, Q, R, S) comprennent deux conducteurs de signal (N, O, P, Q, R, S) qui assurent la fonction d'une ligne de mesure.

4. Table selon l'une des revendications précédentes, **caractérisée en ce que** les conducteurs de signal (N, O, P, Q, R, S) comprennent deux conducteurs de signal (N, O, P, Q, R, S) qui assurent la fonction de l'alimentation en courant de l'adaptateur (13) respectif.

5. Table selon l'une des revendications précédentes, **caractérisée en ce que** la plaque d'enfichage (15) est composée de plusieurs modules d'enfichage (2) et peut être agrandie et/ou réduite par ajout et/ou retrait d'autres modules d'enfichage (2) si besoin dans la direction longitudinale et/ou transversale.

6. Table selon la revendication 5, **caractérisée en ce que** les modules d'enfichage (2) sont délimités de manière carrée, rhombique ou hexagonale.

7. Table selon l'une des revendications précédentes, comprenant un kit constitué comme un module d'au moins une plaque de base, un adaptateur (13) et un module d'enfichage (2) qui sont emboîtables et détachables les uns des autres par commande informatique si besoin pour la pose, le montage et la vérification géométriquement corrects d'un faisceau de câbles (1).
